# EUROPEAN PATENT SPECIFICATION

(11) **EP 4 463 895 B1**
(45) Date of publication and mention of the grant of the patent: **05.11.2025**
(21) Application number: 22840313.5
(22) Date of filing: 15.12.2022
(51) Int. Cl.: H02S 20/30, H10F 77/42, H10F 77/45, H02S 40/22, H02S 30/20

(54) **COMPACT CONCENTRATOR PHOTOVOLTAIC PANEL**
KOMPAKTE KONZENTRIERENDE FOTOVOLTAISCHE TAFEL
PANNEAU PHOTOVOLTAÏQUE À CONCENTRATION COMPACTE

(30) Priority: 12.01.2022 IT 202200000377
(43) Date of publication of application: 20.11.2024
(73) Proprietor: RICERCA & RINNOVABILI S.R.L., 16149 Genova (GE) (IT)
(72) Inventor: REPETTO, Matteo, 16149 Genova (GE) (IT)
(74) Representative: Concone, Emanuele
(86) International application number: PCT/IB2022/062273
(87) International publication number: WO 2023/135473

(56) References cited:
- WO-A1-2009/037386
- DE-A1- 4 338 736
- RU-U1- 193 323

## Description

The present invention represents a compact concentrating photovoltaic system using solar concentration, spectral conversion and a microstructured semiconductor layer to increase the absorption of solar energy and the consequent conversion into electric energy.

To date, after a long technical and culture path and under the push of a pressing climatic crisis, at last the renewable energies have become competitive with respect to the fossil ones.

The fact of producing electricity with solar energy has become much cheaper than in past and then in order to obtain one Kw from solar source one spends as (or even less) to obtain one Kw from fossil source.

The Gws of power installed and produced with solar energy overcame the installations of other types of renewable energy and even the fossil ones, just consider that in 2020 138 GWs of power from solar source were installed (about 39% of the total), more than twice with respect to the installations from fossil source (about 17%); moreover, since 2018 more than ten nations installed 1 Gw - in 2020 there were 18 - of power from solar energy per year by strengthening the leadership of the solar sector with respect to all other ones.

From the technical point of view the development of solutions suitable to keep the costs of the photovoltaic panels down remains to be very important, but there was even a considerable push towards new technological solutions to increase the effectiveness of the panels as well as the use thereof.

In the technical panorama then some generations of technologies can be detected:
✔ 1^{st} generation: Up to now it represents the most widespread and reliable technology, consisting of photovoltaic panels made of mono or poly crystalline silicon and with effectiveness around 25%; on this technology great efforts were concentrated in order to make it cheaper and more efficient to "keep the pace" of competition. In this direction then for example "Perc" (acronym of "Passivated emitter and rear contact") cells were developed, characterized by one passivating rear layer, capable of reflecting and recovering the light not absorbed by the wafer or the so-called "half cells" in which the cell is cut into two smaller cells to reduce the resistance losses and to increase performances, or the multibusbar cells in which the busbars approach to decrease further the resistance losses still to the advantage of the performances, and at last the cells with big sizes (from about 160x160 mm to 210x210mm) so as to decrease the number of cells but to reach remarkable powers, especially if combined with the preceding techniques.
✔ 2^{nd} generation: also known as thin film technology, by now it is almost "equal" to the preceding one from the point of view of the detected effectiveness and the spread on the market. Among the most widespread materials there are the cells made of cis (copper-indium-selenium), cigs (copper-indium-gallium-selenium), cdte (cadmium Telluride) and made of thin film of silicon in the amorphous or microamorphous forms, however with effectiveness around 22%. Even here from the technical point of view there were great progresses with the introduction of the HJT cells (acronym of "Heterojunction technology") in which layers of amorphous silicon were deposited in the order of few tens of nanometres until the micron above the crystalline silicon, and with the "tandem/multilayer" cells in which several layers made of different material with different bandgap are deposited one each other with the purpose of absorbing a greater portion of solar spectrum.
✔ 3^{rd} generation: Opv Cells (Organic Photovoltaic/ organic cells) and Graetzel Cells (DSC, Dye sensityzed solar cell/dye cells) belong to this group, in which the material allowing to absorb and produce energy changes completely, going from silicon to the polymeric materials until the organic dyes such as in case of Graetzel cells. They are not widespread to the levels of the first two cells, but they are always constantly developing, so that Dscs have reached the effectiveness of 13.5% in laboratory whereas Opvs are about 12%.
   Even the Quantum dots or colloidal quantum dots, crystals in the order of the nanometre which can vary the absorption and emission wavelength depending upon the size change belong to this generation; the smallest dots emit in violet and the biggest ones in red. This technology has still wide margins for improving the stability of the crystals' performance, but it could represent a valid alternative to the other ones.
✔ 4^{th} generation: they are the cells made of Perovskite (calcium titanium dioxide), probably the heirs of those made of silicon and they seem to be able to have better effectiveness and absorption, so that in few years, between 2009 and 2016, they have achieved effectiveness of 22%. Recently, they have been used in tandem with the cells made of silicon by showing a great potential.

However, it is still better to focus the research towards the improvement of the effectiveness in the photovoltaic conversion of solar cells by modifying the solar spectrum and by using nanostructured materials as it happens for the above-mentioned quantum dots and in the development of the processes of up-conversion and down-conversion in which one or more photons can contribute to convert some wavelengths towards the best ones for the semiconductor layer.

Generally, these elements are mixed with plastic materials, thus obtaining particular luminescent or transparent plates capable of assisting the semiconductor layers for the production of electric energy by exploiting in some cases the particular effect of "wave guide" of the plate.

It is known that the light cannot be wholly converted into electric energy. Some photons have not sufficient energy to start the photoelectric effect, other ones, instead, have excessing energy which is wasted.

In case of silicon, all photons with wavelength higher than 1.11 micron cannot implement the photoelectric effect considering that their energy is lower than the gap energy (1.12 ev) indeed required to the silicon. The photons having wavelength lower than 1,11 micron, instead, can develop such effect but they convert only 1.12 ev and since they have higher energy, this is not converted and it is transformed into heat.

In case of silicon, 30.2% of energy is lost due to the inability to subtract from the photon more than 1.12 ev, 20.2% is lost since the photons do not have sufficient energy to originate the photoelectric effect. As it is known in literature, the theoretically available maximum energy then is about 49.6%.

The present invention, always by using as material common silicon Si (or Sic), aims at exploiting, as it will be described in details hereinafter, as much as possible about 50% of the unused solar radiation.

According to an aspect of the invention, such result is possible by the combination of three factors:
1. The solar concentration.
2. The spectral conversion.
3. The use of a highly absorbent microstructured semiconductor layer.

RU193323U1 discloses a photovoltaic panel with reflective wings according to the preamble of claim 1.

The present invention then involves several advantages and uses:
a. Better occupied space/obtainable power relationship:
   Thanks to the use of the above-mentioned three factors, it is possible to obtain remarkable power while remaining well below the square meter when the products currently on the market have a "normal" extension beyond 1.5 mq.
   An important application result of this feature can be used directly in the emerging field of the "green" hydrogen production, that is in the hydrogen production through water electrolysis and without the production of climate-altering agents.
   More concretely, the implementation of stations for the hydrogen production can be planned in the unused or abandoned areas which due to reduced extension or complicated geographic localization would not allow the solar-hydrogen combination by using the products currently on the market, in this way by supporting the transition towards both public and private electric mobility and by reducing the production in city areas of Co2 and other harmful gases responsible, apart from the well-known effects, even for the formation of the "heat islands": real bubbles of heat and greenhouse gases which stagnate in the strongly anthropized places by contributing to make the environment unhealthy and harmful to the inhabitants.
   Not stopping on the contrast of the climate-altering agent, another practical example which the above-mentioned feature may have, even consists in recovering abandoned city areas but this time with the double purpose of transforming them into "district energy areas" that is areas in which energy is produced and stored which can be exploited by the neighbouring areas (the districts indeed), but even in areas usable by people both for outdoor activities and for cultural events (exhibitions, concerts, events, etc.) by increasing the life quality offered by the town and involving actively the citizenship by favouring the sociability thereof.
b. Greater versatility and architectural integration:
   Aspect of great importance of the invention which relates to its capability of being able to be installed on each type of (horizontal-vertical-oblique) surface thanks to its particular retractable frame; this widens considerably "the audience" of structures "energizable" with renewable source to the advantage of the reduction in costs, energy consumptions and climate-altering emissions and, moreover, it favours the integration of the new compact concentrating module (CPV) in the building envelope - whatever it is and with any use destination - according to the dictates of Bipv techniques, acronym of "Building Integration Photovoltaic", according thereto the building concept evolves which is put into relation and planned already upstream together with the photovoltaic/solar structures which become structural portion thereof. Moreover, it favours even the alignment with the more recent European legislations in the field which promoted the construction of "NZEB" that is "Net zero energy building": in fact, the new buildings should demonstrate to consume "almost zero energy", becoming buildings sustainable from this point of view and in conclusion less impacting on the climate.
   Still, this feature of the invention will also favour the energy retrofitting of the already existing buildings allowing - similarly to what happens in Bipv - even to them to cut drastically their energy consumption and the production of climate-altering agents by mitigating the city heat islands. It is to be noted that this improvement plays a fundamental role against the climatic change since the "old" structures, in Italy as well as in most Europe, are still the majority with respect to the new ones and then the fact of "recovering them" means a great step forward towards the goals prefixed by the European Union in its directives including the "green deal".
c. Better exploitation of the solar radiation:
   This feature has a double valence which underlines the effectiveness of the new photovoltaic panel: on one side it highlights the way in which the spectrum converters could convert certain wavelengths towards a region of better spectral absorption for the semiconductor layer, on the other side it highlights the way in which the particular micro-structuration of the semiconductor layer consisting in particular vertical structures, such as pillars, could absorb more effectively these waves with less problems linked to the reflection or other types of loss by converting much more radiation into electric energy.
   Moreover, it is necessary to consider that the whole radiation which is captured by the panel reaches the microstructured layer while being concentrated thanks to its evolved optical system - which even provides for tracking the position of the sun throughout the day by increasing the hours useful for the solar collection of 2-4 hours/day - on a reduced surface by decreasing the use of required raw materials and by further maximizing energy conversion, absorption and production. Obviously, the conversion coefficients of the optical system will be accurately calibrated and studied with the purpose of not overheating beyond a certain limit the photovoltaic cell in order not to affect the final effectiveness thereof.
d. Night activity and accumulation implementation:
   As widely known to the current state of art, the accumulator is the component of the photovoltaic system which guarantees the capability of responding adequately to the electric demand by the load. This component substantially consists of particular batteries which guarantee the energy storage and use. Its role is to integrate the power supplied by the photovoltaic system should this be overcome by the demand of the load, or to feed directly the load during the night with the surplus of energy in case generated during the day by the photovoltaic system and stored for the required moments.
   A correct sizing of the photovoltaic and accumulation system then has the purpose of defining the right configuration thereof to respond at best to the energy demand of the load.
   Currently the market allows to select among three groups: the lead-acid accumulators or nickel-cadmium accumulators of the Lithium family. The latter, thanks to a lower weight and higher charge density, are having a great diffusion with respect to the first two groups in several fields, especially in electronics and automotive as main material of batteries to guarantee acceptable travels to new electric vehicles; however, all this notwithstanding the by now evident extractive difficulties to obtain it and the consequent environmental problems even linked to its end-of-life recycling.
   Given that the energy accumulation in the photovoltaic field is required and dutiful both because energy is in itself precious and it should not be wasted and because this energy source, even if clean, is inconstant since it has periods of poor "direct" production caused by the climate variability of the place, the invention proposes to implement/assist the accumulation system with the new night function that is consisting in producing a small amount of energy even during the night hours when the solutions currently existing on the market are capable of producing "zero" energy.
   Such function will be assigned to the above-mentioned spectrum converters which, depending upon their internal composition, could emit by phosphorescence the converted wavelengths towards the semiconductor layer with decreasing intensity during the night "by activating" the semiconductor layer which will produce a small amount of energy to be stored.

The CPV concentrator, the present invention relates to, consists, as it will be described in details hereinafter in relation to a preferred embodiment thereof herein shown by way of example and not for limitative purposes, of:
a. A frame inside thereof the active portion of the device is placed and such frame in case could receive more than one active portion; the frame is motorized with small electric motors or actuators which confer it the possibility of spreading out or retracting and of tracking the motion of the sun. Even four reflective surfaces belong to the frame, which are electrically re-foldable too and each one covering half front area and a transparent front lens capable of concentrating the incident solar rays in particular way.
b. An active portion consisting of a bifacial semiconductor layer microstructured in particular vertical structures, such as pillars, on one or two faces (and in case coated with tco: transparent conductive oxide) comprised between two spectrum converters consisting of two truncated-pyramidal plates made of plastic material in which particular luminescent substances are mixed (both of them phosphorescent or, alternatively, one fluorescent and the other one phosphorescent) "doped" with "activator" elements with the purpose of obtaining a particular photo-conversion towards a radiation with wavelength corresponding to the minimum direct bandgap of the microstructured semiconductor layer. The upper plate is configured to capture and convert portions of Uv-Vis and the lower one to capture and convert portions of Ir. The plates are equipped with strips of material reflecting on its own oblique sides (and on the minor base of the plate "Ir") to favour the directionality of the photons re-emitted after the spectral conversion towards the above-mentioned layer. Alternatively, a configuration is possible providing only the bifacial semiconductor layer microstructured in particular vertical structures, such as pillars, on one or two sides (and in case coated with tco: transparent conductive oxide) standing above a reflective surface, suitable to make the not captured radiation to bounce again towards the layer.

### Brief description of the drawings

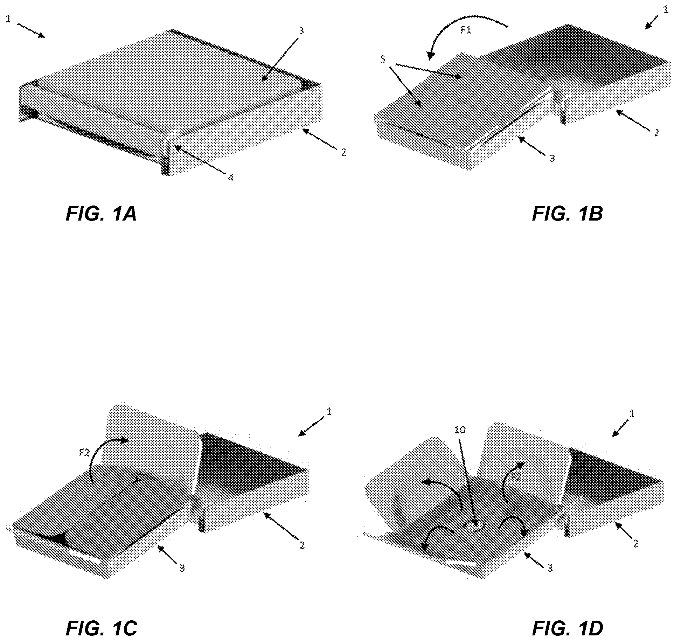

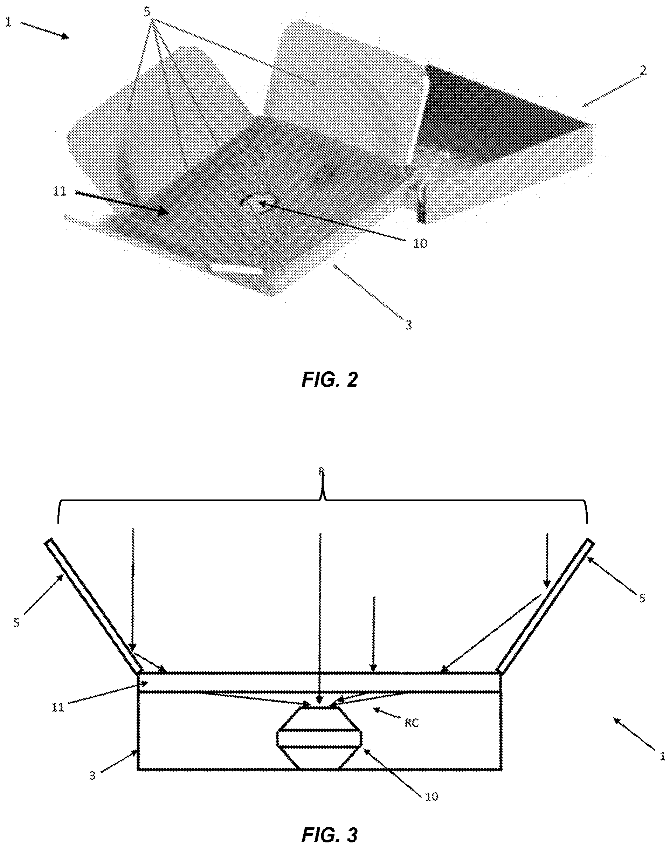

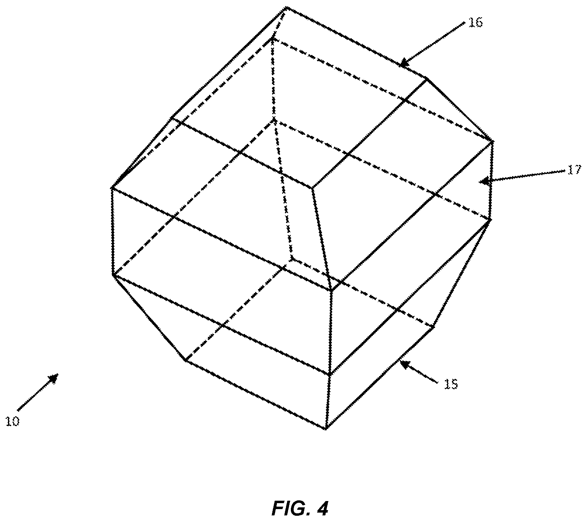

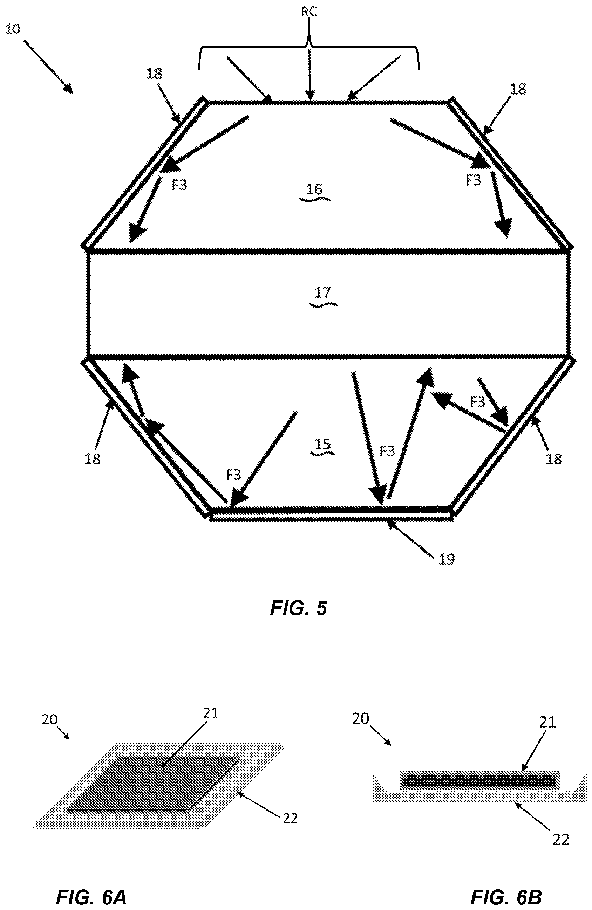

Still additional advantages, as well as the features and use modes of the present invention, will result evident from the following detailed description of a preferred embodiment thereof, shown by way of example and not for limitative purposes, by making reference to the figures of the enclosed drawings, wherein:
✔ figures 1A to 1D show a sequence representing a CPV panel according to the invention, during the opening steps.
✔ figure 2 shows the image of a CPV panel according to the invention, open with the highlighted constituting portions.
✔ figure 3 shows a CPV panel according to the invention in section containing one single active component (in this case, the version with spectrum converters).
✔ figure 4 shows the active component only.
✔ figure 5 shows the active component in section.
✔ Figures 6A and 6B show an alternative embodiment of the active component.

### Detailed description of the drawings

With reference to figures 1A to 1D the CPV panel 1 according to the invention is shown, in its opening dynamics starting from a closed position until an open position, ready to receive solar radiation. A frame comprising a fixed portion 2 and a foldable and orientable portion 3. Such portion 3 is preferably orientable depending upon the sun path. The foldable portion 3 is hinged to the fixed portion 2 at a pin 4 therearound it can rotate.

Four reflective wings 5 belong to the portion 3, since they are hinged thereto, each wing of which covering about half area delimited by the frame portion 3 and provided with opening and closing motion.

Inside the frame portion 3, and positioned centrally, one active component 10 is inserted, advantageously placed below a concentrator plate 11 made of pmma (polymethylmethacrylate), suitable to convey the solar rays and those reflected by the four wings 5 on the active component 10, apart from protecting the same active component 10 from the atmospheric agents.

By now making reference to figure 2, the open CPV panel is shown.

As it can be seen from figure 3 with the representation in section of the frame portion 3 the correct position of all mentioned elements can be noted, including the path of the solar rays R concentrated by the plate 11 towards the active component 10.

In figure 4 the active component 10 is then shown in three-quarter view to underline the components thereof providing a microstructured semiconductor layer 17 (wherein clearly the micro-structuring is not visible) positioned between two spectrum-converting truncated pyramidal plates 15 and 16; in the specific case, the above-mentioned layer 17 is sandwich-like closed between the major bases of the two truncated pyramidal plates 15 and 16.

Moreover, preferably, the upper truncated pyramidal plate 16 has four chrome strips 18 along its oblique sides whereas the lower plate 15 in addition to the four oblique sides provides a chrome strip 19 even on its minor base, with the purpose of reflecting the radiation entering towards the microstructured layer.

Figure 5 shows the active component 10 in section, indeed by highlighting the arrangement of the above-mentioned chrome/reflecting strips 18, 19 in relation to the coupling with the microstructured layer 17.

According to an alternative embodiment, the active component 20 (Figures 6A-6B) can be implemented more simply by one single microstructured layer 21 superimposed on a concave reflective support 22.

In both cases, the solar radiation R arrives perpendicularly with respect to the portion 3 of the CPV panel 1, partially reflected by the four reflective wings 5, and it is concentrated by the concentrator plate 11 in a radiation RC directed towards the active component 10, in particular towards the microstructured layer 17 or 21.

According to the first described embodiment, at first the radiation RC passes through the trapezoidal plate 16 in which a portion of the component Uv-Vis is processed and re-emitted by phosphorescence both towards the mirrored oblique sides 18 and directly towards the underlying microstructured semiconductor layer 17.

The portion of solar radiation going beyond the plate 16 without being processed is collected directly by the semiconductor layer and transformed into electric energy.

On the contrary, the portion of solar radiation RC which does not succeed in producing photovoltaic effect is intercepted and processed by the trapezoidal plate 15 and afterwards re-addressed, even thanks to the reflective strips on the oblique sides 18 and on the minor base 19, again towards the semiconductor layer 17 and then absorbed like the other ones.

It is to be noted that the version highlighted in figures 6A-6B represents a simplified version of the above-mentioned device, in which the concentrated radiation RC arrives from the frame directly on the microstructured semiconductor layer 21 and it is absorbed and processed without any supply of the upper converter plate. On the contrary, the portion of radiation RC going beyond the microstructured semiconductor layer without causing the photovoltaic effect since without sufficient energy, bounces on the lower reflecting surface 22 and going back towards the semiconductor layer 21 is re-absorbed too.

The present invention has been sofar described with reference to preferred embodiments thereof. It is to be meant that each one of the technical solutions implemented in the preferred embodiments, herein described by way of example, can advantageously be combined, differently from what described, with the other ones, to create additional embodiments, belonging to the same inventive core and however all within the protective scope of the herebelow reported claims.

## Claims

1. A compact concentrating photovoltaic panel (1) comprising:
- a frame having a first fixed portion (2) and a foldable and rotatable portion for tracking the position of the sun (3);
- a plurality of reflective and closable wings (5) hinged along a perimeter edge of said foldable portion (3), and configured to collect solar radiation (R) and direct it towards the inside of the foldable portion (3);
- at least one active component (10, 20) arranged inside said foldable portion (3), configured to receive the solar radiation (R) both direct and reflected by the reflecting wings (5),
wherein said at least one active component (10, 20) comprises a layer (17, 21) of bifacial semiconductor material microstructured in an array of vertical structures, such as "pillars", on one or both faces,
**characterized in that**
the at least one active component (10) comprises an upper truncated pyramidal spectrum converter (16) and a lower truncated pyramidal spectrum converter (15), having their respective major bases on the two faces of the microstructured layer (17), or the layer (21) of the at least one active component (20) is superimposed on a concave reflective support (22).

2. The compact concentrating photovoltaic panel (1) according to claim 1, further comprising a concentrator plate (11), configured to concentrate the solar radiation (R) towards said active component (10, 20).

3. The compact concentrating photovoltaic panel (1) according to claim 2, wherein said concentrator plate (11) is placed above the active component (10, 20).

4. The compact concentrating photovoltaic panel (1) according to any of the preceding claims, wherein said truncated pyramidal spectrum converters (15, 16) comprise reflective strips (18) to cover their respective oblique faces, to direct the incident radiation towards the layer of microstructured material (17).

5. The compact concentrating photovoltaic panel (1) according to any of the preceding claims, wherein said truncated pyramidal spectrum converters (15, 16) inside thereof comprise phosphorescent elements doped with several activating elements suitable for converting portions of solar radiation towards a radiation with wavelength corresponding to the minimum direct bandgap of the microstructured semiconductor layer (17).

6. The compact concentrating photovoltaic panel (1) according to any of claims 1 to 4, wherein said truncated pyramidal spectrum converter (16) is mixed inside thereof with one or more phosphorescent elements doped with one or more activating elements so as to convert portions of solar radiation Uv-Visible towards a radiation with wavelength corresponding to the minimum direct bandgap of the microstructured semiconductor layer (17).

7. The compact concentrating photovoltaic panel (1) according to any of claims 1 to 4, wherein said truncated pyramidal spectrum converter (16) is mixed inside thereof with one or more fluorescent elements doped with one or more activating elements so as to convert portions of solar Uv-Visible radiation towards a radiation with wavelength corresponding to the minimum direct bandgap of the microstructured semiconductor layer (17).

8. The compact concentrating photovoltaic panel (1) according to any of claims 1 to 4, wherein said truncated pyramidal spectrum converter (15) is mixed inside thereof with one or more phosphorescent elements doped with one or more activating elements so as to convert portions of solar Infrared radiation towards a radiation with wavelength corresponding to the minimum direct bandgap of the microstructured semiconductor layer (17).

9. The compact concentrating photovoltaic panel (1) according to any of the preceding claims, wherein said lower truncated pyramidal spectrum converter (15) comprises a base reflective strip (19) to cover its minor base to reflect the incident radiation towards the layer of microstructured material (17).

10. The compact concentrating photovoltaic panel (1) according to one of the preceding claims, wherein said layer of microstructured bifacial semiconductor material is coated with TCO.

11. The compact concentrating photovoltaic panel (1) according to one of the preceding claims, comprising four reflective wings (5).

12. The compact concentrating photovoltaic panel (1) according to one of the preceding claims, wherein said reflective wings (5) are hinged along corresponding edges of the foldable portion (3) of the frame and they are foldable over the concentrator plate (11) too.

## Patentansprüche

1. Kompaktes konzentrierendes Photovoltaikpanel (1), umfassend:
- einen Rahmen mit einem ersten festen Abschnitt (2) und einem faltbaren und drehbaren Abschnitt zum Nachverfolgen der Position der Sonne (3);
- eine Vielzahl reflektierender und verschließbarer Flügel (5), die entlang einer Umfangskante des faltbaren Abschnitts (3) gelenkig damit verbunden sind und konfiguriert sind, um Sonnenstrahlung (R) zu sammeln und in Richtung des Inneren des faltbaren Abschnitts (3) zu lenken;
- mindestens eine aktive Komponente (10, 20), die im Inneren des faltbaren Abschnitts (3) angeordnet ist und konfiguriert ist, um die Sonnenstrahlung (R) sowohl direkt als auch von den reflektierenden Flügeln (5) reflektiert zu empfangen,
wobei die mindestens eine aktive Komponente (10, 20) eine Schicht (17, 21) aus bifazialem Halbleitermaterial umfasst, das auf einer oder beiden Flächen in einer Anordnung vertikaler Strukturen, beispielsweise "Säulen", mikrostrukturiert ist,
**dadurch gekennzeichnet, dass**
die mindestens eine aktive Komponente (10) einen oberen pyramidenstumpfförmigen Spektrumkonverter (16) und einen unteren pyramidenstumpfförmigen Spektrumkonverter (15) umfasst, deren jeweilige Hauptbasen auf den beiden Flächen der mikrostrukturierten Schicht (17) liegen, oder die Schicht (21) der mindestens einen aktiven Komponente (20) auf einen konkaven reflektierenden Träger (22) aufgelegt ist.

2. Kompaktes konzentrierendes Photovoltaikpanel (1) nach Anspruch 1, das ferner eine Konzentratorplatte (11) umfasst, die konfiguriert ist, um die Sonnenstrahlung (R) in Richtung der aktiven Komponente (10, 20) zu konzentrieren.

3. Kompaktes konzentrierendes Photovoltaikpanel (1) nach Anspruch 2, wobei die Konzentratorplatte (11) über der aktiven Komponente (10, 20) angeordnet ist.

4. Kompaktes konzentrierendes Photovoltaikpanel (1) nach einem der vorstehenden Ansprüche, wobei die pyramidenstumpfförmigen Spektrumkonverter (15, 16) reflektierende Streifen (18) aufweisen, um ihre jeweiligen schrägen Flächen abzudecken und die einfallende Strahlung auf die Schicht aus mikrostrukturiertem Material (17) zu lenken.

5. Kompaktes konzentrierendes Photovoltaikpanel (1) nach einem der vorstehenden Ansprüche, wobei die pyramidenstumpfförmigen Spektrumkonverter (15, 16) in ihrem Inneren phosphoreszierende Elemente umfassen, die mit mehreren Aktivierungselementen dotiert sind, die geeignet sind, um Abschnitte der Sonnenstrahlung in eine Strahlung mit einer Wellenlänge umzuwandeln, die der minimalen direkten Bandlücke der mikrostrukturierten Halbleiterschicht (17) entspricht.

6. Kompaktes konzentrierendes Photovoltaikpanel (1) nach einem der Ansprüche 1 bis 4, wobei der pyramidenstumpfförmige Spektrumkonverter (16) in seinem Inneren mit einem oder mehreren phosphoreszierenden Elementen gemischt ist, die mit einem oder mehreren aktivierenden Elementen dotiert sind, um Abschnitte der Sonnenstrahlung im UV- bis sichtbaren Bereich in Strahlung mit einer Wellenlänge umzuwandeln, die der minimalen direkten Bandlücke der mikrostrukturierten Halbleiterschicht (17) entspricht.

7. Kompaktes konzentrierendes Photovoltaikpanel (1) nach einem der Ansprüche 1 bis 4, wobei der pyramidenstumpfförmige Spektrumkonverter (16) in seinem Inneren mit einem oder mehreren fluoreszierenden Elementen gemischt ist, die mit einem oder mehreren aktivierenden Elementen dotiert sind, um Abschnitte der UV- bis sichtbaren Sonnenstrahlung in eine Strahlung mit einer Wellenlänge umzuwandeln, die der minimalen direkten Bandlücke der mikrostrukturierten Halbleiterschicht (17) entspricht.

8. Kompaktes konzentrierendes Photovoltaikpanel (1) nach einem der Ansprüche 1 bis 4, wobei der pyramidenstumpfförmige Spektrumkonverter (15) in seinem Inneren mit einem oder mehreren phosphoreszierenden Elementen gemischt ist, die mit einem oder mehreren aktivierenden Elementen dotiert sind, um Abschnitte der solaren Infrarotstrahlung in eine Strahlung mit einer Wellenlänge umzuwandeln, die der minimalen direkten Bandlücke der mikrostrukturierten Halbleiterschicht (17) entspricht.

9. Kompaktes konzentrierendes Photovoltaikpanel (1) nach einem der vorstehenden Ansprüche, wobei der untere pyramidenstumpfförmige Spektrumkonverter (15) einen reflektierenden Basisstreifen (19) aufweist, der seine kleinere Basis bedeckt, um die einfallende Strahlung in Richtung der Schicht aus mikrostrukturiertem Material (17) zu reflektieren.

10. Kompaktes konzentrierendes Photovoltaikpanel (1) nach einem der vorstehenden Ansprüche, wobei die Schicht aus mikrostrukturiertem bifazialen Halbleitermaterial mit TCO beschichtet ist.

11. Kompaktes konzentrierendes Photovoltaikpanel (1) nach einem der vorstehenden Ansprüche, umfassend vier reflektierende Flügel (5).

12. Kompaktes konzentrierendes Photovoltaikpanel (1) nach einem der vorstehenden Ansprüche, wobei die reflektierenden Flügel (5) entlang entsprechender Kanten des faltbaren Abschnitts (3) des Rahmens gelenkig verbunden sind und auch über die Konzentratorplatte (11) faltbar sind.

## Revendications

1. Panneau photovoltaïque compact à concentration (1) comprenant :
- un cadre ayant une première partie fixe (2) et une partie pliable et rotative pour suivre la position du soleil (3) ;
- une pluralité d'ailes réfléchissantes et fermables (5) articulées le long d'un bord périmétrique de ladite partie pliable (3), et configurées pour collecter le rayonnement solaire (R) et le diriger vers l'intérieur de la partie pliable (3) ;
- au moins un composant actif (10, 20) disposé à l'intérieur de ladite partie pliable (3), configuré pour recevoir le rayonnement solaire (R) à la fois direct et réfléchi par les ailes réfléchissantes (5),
dans lequel ledit au moins un composant actif (10, 20) comprend une couche (17, 21) de matériau semi-conducteur bifacial microstructuré en un réseau de structures verticales, telles que des "piliers", sur l'une des faces ou sur les deux,
**caractérisé en ce que**
l'au moins un composant actif (10) comprend un convertisseur de spectre pyramidal tronqué supérieur (16) et un convertisseur de spectre pyramidal tronqué inférieur (15), ayant leurs bases principales respectives sur les deux faces de la couche microstructurée (17), ou la couche (21) de l'au moins un composant actif (20) est superposée à un support réfléchissant concave (22).

2. Panneau photovoltaïque compact à concentration (1) selon la revendication 1, comprenant en outre une plaque concentratrice (11), configurée pour concentrer le rayonnement solaire (R) vers ledit composant actif (10, 20).

3. Panneau photovoltaïque compact à concentration (1) selon la revendication 2, dans lequel ladite plaque concentratrice (11) est placée au-dessus du composant actif (10, 20).

4. Panneau photovoltaïque compact à concentration (1) selon l'une quelconque des revendications précédentes, dans lequel lesdits convertisseurs de spectre à pyramide tronquée (15, 16) comprennent des bandes réfléchissantes (18) pour couvrir leurs faces obliques respectives, afin de diriger le rayonnement incident vers la couche de matériau microstructuré (17).

5. Panneau photovoltaïque compact à concentration (1) selon l'une quelconque des revendications précédentes, dans lequel lesdits convertisseurs de spectre à pyramide tronquée (15, 16) à l'intérieur de celui-ci comprennent des éléments phosphorescents dopés avec plusieurs éléments d'activation aptes à convertir des parties du rayonnement solaire vers un rayonnement dont la longueur d'onde correspond à la bande interdite minimale de la couche semi-conductrice microstructurée (17).

6. Panneau photovoltaïque compact à concentration (1) selon l'une quelconque des revendications 1 à 4, dans lequel ledit convertisseur de spectre pyramidal tronqué (16) est mélangé à l'intérieur de celui-ci avec un ou plusieurs éléments phosphorescents dopés avec un ou plusieurs éléments activateurs de façon à convertir des portions du rayonnement solaire UV-visible vers un rayonnement dont la longueur d'onde correspond à la bande interdite minimale de la couche semi-conductrice microstructurée (17).

7. Panneau photovoltaïque compact à concentration (1) selon l'une quelconque des revendications 1 à 4, dans lequel ledit convertisseur de spectre pyramidal tronqué (16) est mélangé à l'intérieur de celui-ci avec un ou plusieurs éléments fluorescents dopés avec un ou plusieurs éléments activateurs de manière à convertir des portions du rayonnement solaire UV-visible vers un rayonnement dont la longueur d'onde correspond à la bande interdite minimale de la couche semi-conductrice microstructurée (17).

8. Panneau photovoltaïque compact à concentration (1) selon l'une quelconque des revendications 1 à 4, dans lequel ledit convertisseur de spectre pyramidal tronqué (15) est mélangé à l'intérieur de celui-ci avec un ou plusieurs éléments phosphorescents dopés avec un ou plusieurs éléments activateurs de manière à convertir des portions du rayonnement solaire infrarouge vers un rayonnement dont la longueur d'onde correspond à la bande interdite minimale de la couche semi-conductrice microstructurée (17).

9. Panneau photovoltaïque compact à concentration (1) selon l'une quelconque des revendications précédentes, dans lequel ledit convertisseur de spectre pyramidal tronqué inférieur (15) comprend une bande réfléchissante de base (19) pour couvrir sa petite base afin de réfléchir le rayonnement incident vers la couche de matériau microstructuré (17).

10. Panneau photovoltaïque compact à concentration (1) selon l'une quelconque des revendications précédentes, dans lequel ladite couche de matériau semi-conducteur bifacial microstructuré est recouverte de TCO.

11. Panneau photovoltaïque compact à concentration (1) selon l'une des revendications précédentes, comprenant quatre ailes réfléchissantes (5).

12. Panneau photovoltaïque compact à concentration (1) selon l'une quelconque des revendications précédentes, dans lequel les ailes réfléchissantes (5) sont articulées le long des bords correspondants de la partie pliable (3) du cadre et sont pliables sur la plaque concentratrice (11).
